# EUROPEAN PATENT APPLICATION

(11) **EP 4 839 024 A1**
(43) Date of publication of application: **11.11.2026**
(21) Application number: 25175515.3
(22) Date of filing: 09.05.2025
(51) Int. Cl.: H05K 1/02, H05K 1/11, H05K 3/34

(54) **INTEGRATED CIRCUIT MODULE, PRINTED CIRCUIT BOARD, AND SYSTEM**

(71) Applicant: Harman Becker Automotive Systems, Inc., Novi, MI 48377 (US)
(72) Inventor: KUSKA, Andreas, 76287 Rheinstetten (DE)
(74) Representative: Maucher Jenkins Patent- und Rechtsanwälte Partnerschaft mbB

(57) **Abstract**

An integrated circuit, IC, module (100), a printed circuit board, PCB, the PCB being configured to be electrically connected with the IC module (100), and a system including the IC module (100) and the PCB are provided. The IC module (100) includes a contact surface (102), and a plurality of electrically conducting contact elements (104) for electrically connecting the IC module (100) to another electronic component (e.g., the PCB), the plurality of contact elements (104) being arranged on the contact surface (102), wherein the plurality of contact elements includes three contact elements (104a, 104b, 104c) that form an equilateral triangle.

## Description

The present invention relates to an integrated circuit, IC, module, a printed circuit board, PCB, and a system including the IC module and the PCB.

### BACKGROUND OF THE INVENTION

For integrated circuit, IC, modules, there is a need to provide a high-speed interfaces to the target board (e.g., a PCB). The interfaces include electrical contact elements (e.g., pins, balls or lands) of the IC module and contact elements of the target board, which are configured to be electrically connected with each other when the IC module is connected to the target board. Often, the high-speed interfaces work in a balanced and/or differential mode. Therefore, care needs to be taken about signal-integrity in order to bring the energy from sink to source with low losses.

Usually, the IC modules, e.g. the ball grid array, BGA, and/or the land grid array, LGA, IC modules use a matrix orientated design for the contact elements (e.g., lands of solder balls), with a rectangular matrix of the contact elements or shifted matrix on every second row. Such samples are designed, e.g., according to the JEDEC standard. However, existing IC modules do not allow for a homogeneous and variable connection to the contact elements around the IC module, in particular, when the IC module is configured to transmit signals in a balanced and/or differential mode.

It is therefore an objective of the present disclosure to provide an IC module, a PCB, and a system including the IC module and the PCB, which allow for homogeneous and variable connection between the contact elements of the IC module and the PCB. Further, it is an objective of the present disclosure to provide an IC module, a PCB, and a system including the IC module and the PCB, which allow to provide high-speed interfaces between the IC module and the PCB, allowing bringing the energy from sink to source with low losses, in particular, when balanced and/or differential signals are transmitted between the IC module and the PCB. Moreover, it is an objective of the present disclosure to provide a contact element pattern for the electrical contact elements of the IC module and the electrical contact elements of the PCB, which enable proper electrical-design, high contact element density, and cost-efficient assembly of the IC module and the PCB.

### SUMMARY

To achieve the above objectives, an integrated circuit, IC, module is provided, including a contact surface, and a plurality of electrically conducting contact elements for electrically connecting the IC module to another electronic component. The plurality of contact elements is arranged on the contact surface, the plurality of contact elements including three contact elements that form an equilateral triangle. Such an arrangement of the contact elements allows a homogeneous and variable connection to the contact elements of the IC module. Moreover, such an arrangement of the contact elements allows a significant improvement of signal quality when balanced and/or differential signaling is used.

Advantageously, the plurality of contact elements is arranged on the contact surface in a triangular lattice. Such an arrangement of the contact elements allows for a homogeneous and variable connection to the contact elements around the IC module.

In a preferred embodiment, the triangular lattice is an equidistant triangular lattice, in which for each of the contact elements, a distance between the contact element and each of its nearest neighboring contact elements is equal. Such an arrangement of the contact elements allows for a homogeneous and variable connection to the contact elements around the IC module. Moreover, such an arrangement of the contact elements has advantageous technical effects of enabling proper electrical design, high contact element density and cost-efficient assembly of the IC module.

In a preferred embodiment, two of the three contact elements that form the equilateral triangle are configured to transmit a differential signal. This allows improving the noise immunity of the signals transmitted to or from the IC module.

Advantageously, a contact element of the three contact elements that form the equilateral triangle, which is not configured to transmit the differential signal, is configured to transmit a ground signal. This allows to significantly reduce the noise and improve the signal quality in the differential signal transmission. Thus, a high-speed signal transmission between the IC module and the other electronic component, which is coupled to the IC module, becomes possible, improving the signal integrity and allowing to bring the signal energy from sink to source with low losses.

In an embodiment, the three contact elements that form the equilateral triangle are nearest neighbors on the triangular lattice. This allows an additional improvement of the signal quality in the differential signal transmission.

In a preferred embodiment, the three contact elements that form the equilateral triangle are located in a peripheral area of the of the contact surface. This allows a further improvement of the noise immunity of the differential signals transmitted to or from the IC module 100. Moreover, this allows a more simple connection of the differential signal lines.

In an embodiment, the plurality of contact elements forms a land grid array, LGA, and/or a ball grid array, BGA. This allows an effective electrical and mechanical connection of the IC module to another electronic component.

Furthermore, to achieve the above objectives, a printed circuit board, PCB, is provided, the PCB being configured to be electrically connected with the IC module as described above. The PCB includes a first surface, and a plurality of electrically conducting PCB contact elements for electrically connecting with the plurality of contact elements of the IC module, the plurality of PCB contact elements being arranged on the first surface of the PCB. The plurality of PCB contact elements includes three contact elements that form an equilateral triangle. Such an arrangement of the PCB contact elements allows for a homogeneous and variable connection to the contact elements around the PCB. Moreover, such an arrangement of the contact elements allows a significant improvement of signal quality when balanced and/or differential signaling is used.

In a preferred embodiment, the PCB contact elements are arranged on the first surface in an equidistant triangular lattice, in which for each of the PCB contact elements, a distance between the PCB contact element and each of its nearest neighboring PCB contact elements is equal. Such an arrangement of the PCB contact elements allows for a homogeneous and variable connection to the contact elements around the PCB. Moreover, such an arrangement of the PCB contact elements has advantageous technical effects of enabling proper electrical design, high contact element density and cost-efficient assembly of the PCB and the IC module.

In a preferred embodiment, two of the three PCB contact elements that form the equilateral triangle are configured to transmit a differential signal, and a PCB contact element of the three PCB contact elements that form the equilateral triangle, which is not configured to transmit the differential signal, is configured to transmit a ground signal. This configuration allows to significantly reduce the noise and improve the signal quality in the differential signal transmission between the PCB and the IC module. Thus, a high-speed signal transmission between the PCB and the IC module becomes possible, improving the signal integrity and allowing to bring the signal energy from sink to source with low losses.

Advantageously, the three PCB contact elements that form the equilateral triangle are nearest neighbors on the equidistant triangular lattice. This allows an additional improvement of the signal quality in the differential signal transmission.

In an embodiment, the three PCB contact elements that form the equilateral triangle are located in a peripheral area of the contact surface. This allows a further improvement of the signal quality in the differential signal transmission.

In a preferred embodiment, the plurality of PCB contact elements forms a land grid array, LGA, and/or a ball grid array, BGA, and/or a pin grid array, PGA. This allows an effective electrical and mechanical connection of the PCB to the IC module.

Moreover, to achieve the above objectives, a system is provided, including the IC module and the PCB as described above, the IC module and the PCB being electrically connected with each other via the plurality of the IC contact elements and the plurality of PCB contact elements. Such a system has advantageous technical effects of a high-speed signal transmission between the IC module and the PCB, improving the signal integrity and allowing to bring the signal energy from sink to source with low losses.

### BRIEF DESCRIPTION OF THE DRAWINGS

The features, objects, and advantages of the present disclosure will become more apparent from the detailed description set forth below when taken in conjunction with the drawings in which like reference numerals refer to similar elements.
Figures 1a and 1b illustrate a schematical partial top view of an integrated circuit, IC, module according to an one of a number of embodiments.
Figures 2a to 2d illustrate a schematical partial top view of an IC module according to one of a number of embodiments.
Figures 3a and 3b illustrate a schematical partial section view of an IC module according to one of a number of embodiments.
Figure 4 shows a schematical partial top view of an IC module according to one of a number of embodiments.
Figure 5 shows a schematical partial top view of a printed circuit board, PCB, according to one of a number of embodiments.
Figure 6 shows a schematical partial section view of a system including an IC module and a PCB, according to one of a number of embodiments.

### DETAILLED DESCRIPTION OF THE PREFERRED EMBODIMENTS

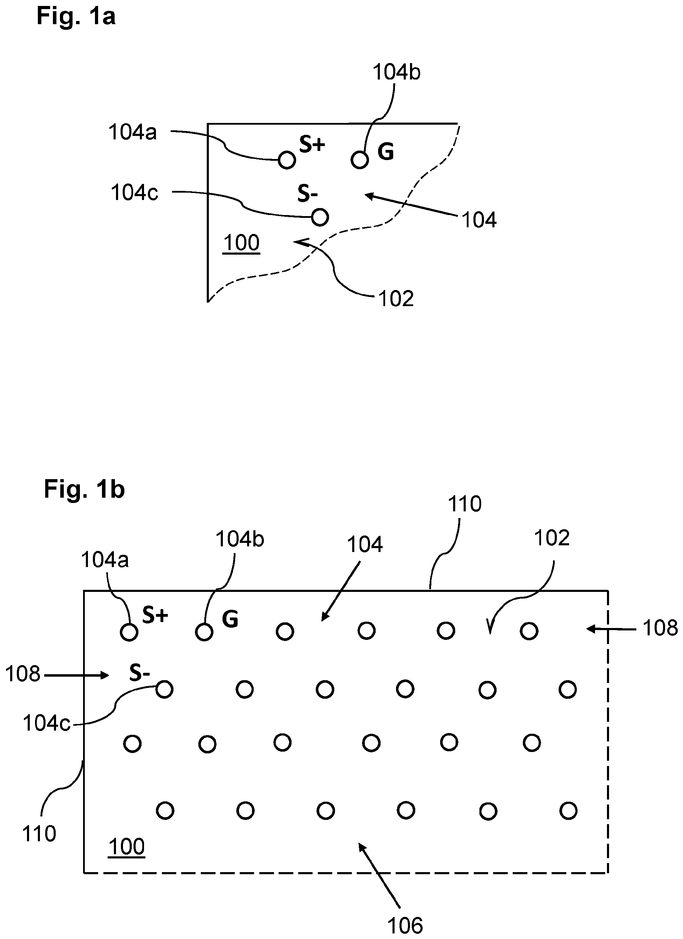

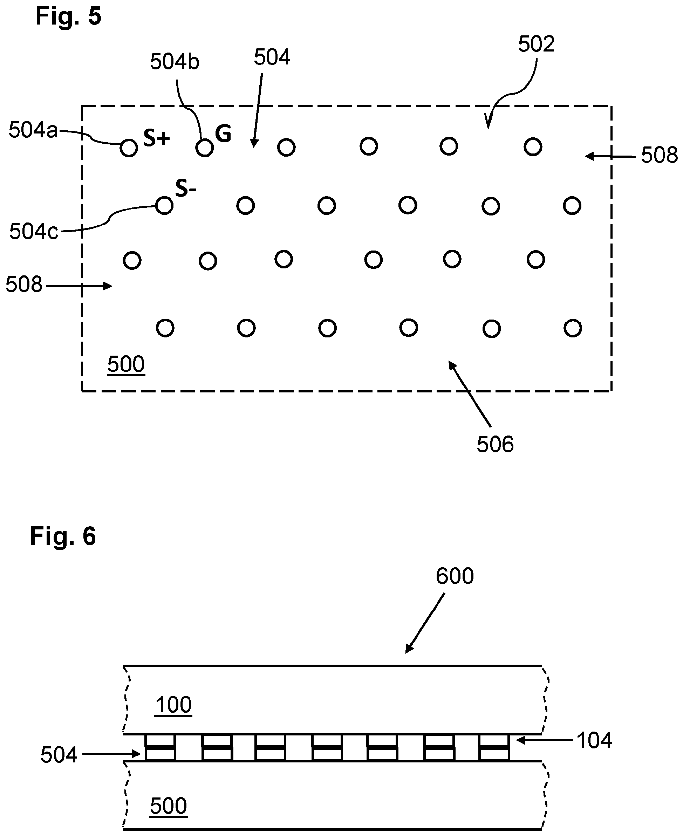

Figure 1a shows a schematical partial top view of an integrated circuit, IC, module 100 according to an embodiment. The IC module 100 includes a contact surface 102, the contact surface 102 being configured to be in contact with another electronic component (not shown), like, e.g., a printed circuit board, PCB (see Figures 5 and 6), when the IC module 100 is electrically connected to the other electronic component. The IC module 100 further includes a plurality of electrically conducting contact elements 104 for electrically connecting the IC module 100 to the other electronic component. The plurality of contact elements 104 is arranged on the contact surface 102.

As shown in Figure 1a, the plurality of contact elements 104 includes at least three contact elements 104a, 104b and 104c that form an equilateral triangle. I.e., a distance between the contact elements 104a and 104b is equal to a distance between the contact elements 104b and 104c and is equal to a distance between the contact elements 104a and 104c. In Figure 1a, the contact elements 104a, 104b and 104c are shown as located in a peripheral area of the contact surface 102, but they can be located in any part of the contact surface 102. Such an arrangement of the contact elements 104 allows for a homogeneous and variable connection to the contact elements of the IC module. Moreover, such an arrangement of the contact elements allows a significant improvement of signal quality when balanced and/or differential signaling is used.

As shown in Figure 1b, which is a partial top view of an IC, module 100 according to an embodiment, the plurality of contact elements 104 may include more than just three contact elements, which may be arranged on the contact surface 102 of the IC module 100 in a triangular lattice 106. The triangular lattice 106 may include the plurality of contact elements 104 being arranged in such a way that each three neighboring contact elements 104, which are nearest neighbors on the triangular lattice 106, form a triangle.

The triangular lattice 106 may be a regular triangular lattice (also known as a hexagonal lattice 106), in which all triples of nearest neighbors of lattice elements form equilateral triangles. Such an arrangement of the contact elements 104 allows for a homogeneous and variable connection to the contact elements around the IC module. Moreover, such an arrangement of the contact elements 104 has advantageous technical effects of enabling proper electrical design, high contact element density and cost-efficient assembly of the IC module.

Turning again to Figure 1a, any pair of the three contact elements 104a, 104b and 104c that form the equilateral triangle may be configured to transmit a balanced signal pair, e.g, a differential signal pair. In the following, the example of the differential signal pair is used for purposes of illustrating the present disclosure, however, also a more general balanced signal pair may be used, also. That is, e.g., the contact element 104a may be configured to transmit a signal S+, while the contact element 104c may be configured to transmit a signal S-, the signals S+ and S- forming a differential signal pair. To this end, the contact elements 104a, 104b can transmit voltage signals V and -V, respectively, which are equal in magnitude, but have an opposite polarity. This allows improving the noise immunity of the signals transmitted to or from the IC module 100.

Moreover, as shown in Figure 1a, a contact element 104b of the three contact elements 104a, 104b and 104c that form the equilateral triangle, which is not configured to transmit the differential signal, may be configured to transmit a ground signal G. Even though a ground signal is not necessarily required in balanced and/or differential signal transmission, the experiments and simulations of the inventor have surprisingly shown that a configuration of the three contact elements 104a, 104b and 104c as shown in Figure 1a and as explained above, with the three contact elements 104a, 104b and 104c forming an equilateral triangle, and any two of the contact elements 104a, 104b and 104c transmitting a differential signal pair, while the third contact element, which is not configured to transmit the differential signal, is configured to transmit a ground signal G, allows to significantly reduce the noise and improve the signal quality in the differential signal transmission. Thus, a high-speed signal transmission between the IC module 100 and the other electronic component, which is coupled to the IC module 100, becomes possible, improving the signal integrity and allowing to bring the signal energy from sink to source with low losses. The ground signal G is required for the parasitic return paths related to the differential pair when having a not ideal differential transmission.

As shown in Figure 1b, the three contact elements 104a, 104b and 104c that form the equilateral triangle may be nearest neighbors on the triangular lattice. This allows an additional improvement of the signal quality in the differential signal transmission.

The three contact elements that form the equilateral triangle may be located in a peripheral area 108 of the contact surface 102, i.e., in the vicinity of an edge 110 of the contact surface 102, as shown in Figure 1b. This allows a further improvement of the noise immunity of the differential signals transmitted to or from the IC module 100. Moreover, this allows a more simple connection of the differential signal lines.

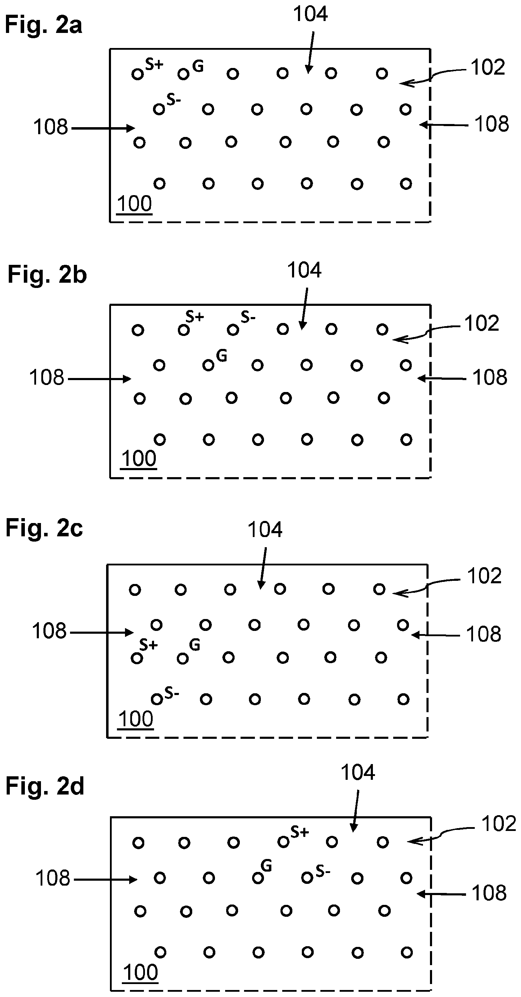

Figures 2a to 2d, each of which illustrates a schematical partial top view of an integrated circuit, IC, module 100, show different possibilities of a connection the differential signal lines with the signals S+ and S-, and a ground signal line with the signal G to the IC module 100, according to embodiments. In Figures 2a to 2d, the contact elements 102 to which the differential signal pair S+, S- is connected, are located in the peripheral area 108 of the contact surface 102 of the IC module 100. In other words, as shown in Figures 2a to 2d, the differential signal pair S+, S- may be connected in the peripheral area 108 of the contact surface 102 around an edge of the IC module 100 to dedicated signals, whereas a neighboring contact element 104 of the contact elements 104 to which the differential signal pair S+, S- is connected, may be connected to the ground signal G. Such an arrangement of the contact elements 104 and signal connection of the differential and ground signals allows a homogeneous and variable connection to the contact elements around the IC module as well as improved signal quality and noise reduction.

As described above, the configuration of the contact elements 104 in a triangular lattice 106 is particularly advantageous when using differential signaling. However, the present disclosure is not limited to using differential signaling, and also single-ended signals can be used. The configuration of the contact elements 104 in a triangular lattice 106 also provides advantageous technical effects in the case of single-ended signals, as described above in connection with Figure 1b.

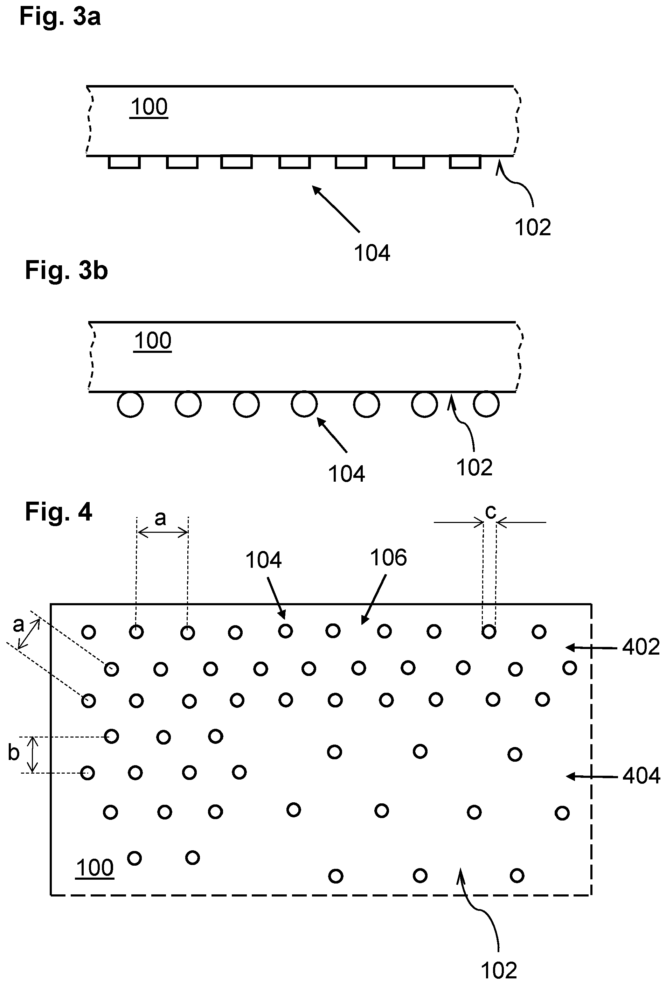

As shown in Figures 3a and 3b, each of which shows a schematical partial section view of the IC module 100, the plurality of contact elements may form a land grid array, LGA (see Figure 3a), and/or a ball grid array, BGA (see Figure 3b). This allows an effective electrical and mechanical connection of the IC module to another electronic component.

Figure 3a shows the plurality of contact elements 104 having the form of lands, which are configured to be connected to a grid of corresponding contacts on another electronic component (not shown), like, e.g., a printed circuit board, PCB (see Figures 5 and 6). Pre-tinning by using solder paste may be used as a connection technique between the lands 104 and the corresponding contacts on the other electronic component in this case, as an example. Figure 3b shows the plurality of contact elements 104 having the form of solder balls 104. In this case, balling by using the solder balls 104 may be used as a connection technique to the corresponding other electronic component like, e.g., a PCB. However, the embodiments are not limited to the LGA and/or the BGA, and the contact elements 104 may also form, e.g., a pin grid array, PGA, or can be any other type of electrical contact elements.

Figure 4 shows a schematical partial top view of an integrated circuit, IC, module 100 according to an embodiment. In Figure 4, a larger part of the contact surface 102 is shown, including a peripheral part 402 and an inner part 404 of the contact surface 102 with the corresponding contact elements 104. As can be seen from Figure 4, the contact elements 104 of the inner part 404 of the contact surface 102 have a smaller surface density than the contact elements 104 of the peripheral part 402 of the contact surface 102, which allows a better disentangling of the corresponding contact lines. In an embodiment, a length a of the equilateral triangles forming the lattice 106 of contact elements 104 can be, e.g., a = 1,400 mm, while the vertical distance b can be, e.g., b = 1,212 mm. This spacing between the contact elements 104 allows using standard PCB design for a target board to which the IC module 100 is configured to be connected. For a diameter c of the contact element 104, e.g., c = 600 µm can be chosen in an embodiment. This diameter of the contact element 104 allows using pre-tinning (for the case of an LGA) or ball-mounting (for the case of a BGA) as an assembly technique for the IC module 100 with the corresponding contacts on the other electronic component, e.g. a PCB. However, the spacings a and b as specified above are not limiting and depend on manufacturing processes and the used contact element (e. g land) diameter c.

Figure 5 shows a schematical partial top view of a printed circuit board, PCB 500 according to an embodiment. The PCB 500 is configured to be electrically connected with the IC module 100. The PCB 500 includes a first surface 502, and a plurality of electrically conducting PCB contact elements 504 for electrically connecting with the plurality of contact elements 104 of the IC module 100. The plurality of PCB contact elements 504 may be arranged on the first surface 502 of the PCB. The first surface thus is configured to face the contact surface 102 of the IC module 100, when the PCB is connected with the IC module 100. The plurality of PCB contact elements 504 of the PCB 500 is configured to fit with the plurality of contact elements 104 of the IC module 100 and thus shares some features and advantages with the latter. Therefore, some details, which have already been described above for the IC module 100, are the same for the PCB 500, and will be omitted in the following.

As shown in Figure 5, the plurality of contact elements includes at least three contact elements 504a, 504b and 504c that form an equilateral triangle. Such an arrangement of the PCB contact elements allows for a homogeneous and variable connection to the contact elements around the PCB. Moreover, such an arrangement of the contact elements allows a significant improvement of signal quality when balanced and/or differential signaling is used.

According to an embodiment, the PCB contact elements 504 may be arranged on the first surface 502 of the PCB in a triangular lattice 506. The triangular lattice 506 is preferably an equidistant triangular lattice 506, in which for each of the PCB contact elements 504, a distance between the PCB contact element 504 and each of its nearest neighboring PCB contact elements 504 is equal. Such an arrangement of the PCB contact elements 504 allows for a homogeneous and variable connection to the contact elements around the PCB. Moreover, such an arrangement of the PCB contact elements 504 has advantageous technical effects of enabling proper electrical design, high contact element density and cost-efficient assembly of the PCB and the IC module.

According to an embodiment, any two of the three PCB contact elements 504a, 504b and 504 c that form the equilateral triangle may be configured to transmit a differential signal S+, S- (e.g., the contact elements 504a and 504c as shown in Figure 5), and a PCB contact element of the three PCB contact elements 504a, 504b and 504 c that form the equilateral triangle, which is not configured to transmit the differential signal, may be configured to transmit a ground signal G (e.g., the contact element 504b as shown in Figure 5). This configuration allows to significantly reduce the noise and improve the signal quality in the differential signal transmission between the PCB 500 and the IC module 100. Thus, a high-speed signal transmission between the PCB 500 and the IC module 100 becomes possible, improving the signal integrity and allowing to bring the signal energy from sink to source with low losses.

In an embodiment, the three PCB contact elements 504a, 504b and 504c that form the equilateral triangle may be nearest neighbors on the equidistant triangular lattice 506. The three PCB contact elements 504a, 504b and 504c that form the equilateral triangle may be located in a peripheral area 508 of the first surface 502 of the PCB 500.

The plurality of PCB contact elements 504 may form a land grid array, LGA, and/or a ball grid array, BGA, corresponding to the LGA and/or the BGA of the IC module 100. However, the embodiments are not limited to the LGA and/or the BGA, and the PCB contact elements 504 may also form, e.g., a pin grid array, PGA, or can be any other type of electrical contact elements.

Figure 6 shows a schematical partial section view of a system 600 including the IC module 100 and the PCB 500 as described above, according to an embodiment. The IC module 100 and the PCB 500 may be electrically connected with each other via the plurality of the IC contact elements 104 and the plurality of PCB contact elements 504 by the technique mentioned above (e.g., pre-tinning, e.g. by using solder paste and/or ball-mounting by using solder balls). In the embodiment shown in Figure 6, the IC contact elements 104 and the PCB contact elements 504 form a land grid array, LGA and may be connected, e.g, using pre-tinning. However, as described above, also a ball grid array, BGA, a pin grid array, PGA, or any other type of electrical contact elements and connection techniques between the contact elements may be used for the IC contact elements 104 and the PCB contact elements 504.

## Claims

1. An integrated circuit, IC, module, including
a contact surface, and
a plurality of electrically conducting contact elements for electrically connecting the IC module to another electronic component, the plurality of contact elements being arranged on the contact surface,
wherein the plurality of contact elements includes three contact elements that form an equilateral triangle.

2. The IC module of any of the preceding claims, wherein the plurality of contact elements is arranged on the contact surface in a triangular lattice.

3. The IC module of claim 2, wherein the triangular lattice is an equidistant triangular lattice, in which for each of the contact elements, a distance between the contact element and each of its nearest neighboring contact elements is equal.

4. The IC module of any of the preceding claims, wherein two of the three contact elements that form the equilateral triangle are configured to transmit a differential signal.

5. The IC module of claim 4, wherein a contact element of the three contact elements that form the equilateral triangle, which is not configured to transmit the differential signal, is configured to transmit a ground signal.

6. The IC module of any of claims 2 to 5, wherein the three contact elements that form the equilateral triangle are nearest neighbors on the triangular lattice.

7. The IC module of any of the preceding claims, wherein the three contact elements that form the equilateral triangle are located in a peripheral area of the of the contact surface.

8. The IC module of any of the preceding claims, wherein the plurality of contact elements forms a land grid array, LGA, and/or a ball grid array, BGA.

9. A printed circuit board, PCB, the PCB being configured to be electrically connected with the IC module according to any of the preceding claims, the PCB including
a first surface, and
a plurality of electrically conducting PCB contact elements for electrically connecting with the plurality of contact elements of the IC module, the plurality of PCB contact elements being arranged on the first surface of the PCB,
wherein the plurality of PCB contact elements includes three contact elements that form an equilateral triangle.

10. The PCB according to claim 9, wherein the PCB contact elements are arranged on the first surface in an equidistant triangular lattice, in which for each of the PCB contact elements, a distance between the PCB contact element and each of its nearest neighboring PCB contact elements is equal.

11. The PCB of any of claims 9 or 10, wherein two of the three PCB contact elements that form the equilateral triangle are configured to transmit a differential signal, and a PCB contact element of the three PCB contact elements that form the equilateral triangle, which is not configured to transmit the differential signal, is configured to transmit a ground signal.

12. The PCB of any of claims 9 to 11, wherein the three PCB contact elements that form the equilateral triangle are nearest neighbors on the equidistant triangular lattice.

13. The PCB of any of claims 9 to 12, wherein the three PCB contact elements that form the equilateral triangle are located in a peripheral area of the contact surface.

14. The PCB of any of claims 9 to 13, wherein the plurality of PCB contact elements forms a land grid array, LGA, and/or a ball grid array, BGA, and/or a pin grid array, PGA.

15. A system including the IC module according to any of claims 1 to 8 and the PCB according to any of claims 9 to 14, the IC module and the PCB being electrically connected with each other via the plurality of the IC contact elements and the plurality of PCB contact elements.
